# EUROPÄISCHE PATENTSCHRIFT

(11) **EP 4 009 058 B1**
(45) Veröffentlichungstag und Bekanntmachung des Hinweises auf die Patenterteilung: **08.01.2025**
(21) Anmeldenummer: 21206461.2
(22) Anmeldetag: 04.11.2021
(51) Int. Cl.: G01R 19/00, G01R 15/14, G01R 15/04

(54) **MESS-VORRICHTUNG ZUR SPANNUNGSMESSUNG**
MEASURING DEVICE FOR VOLTAGE MEASUREMENT
DISPOSITIF DE MESURE DESTINÉ À LA MESURE DE TENSION

(30) Priorität: 02.12.2020 DE 102020215171
(43) Veröffentlichungstag der Anmeldung: 08.06.2022
(73) Patentinhaber: BSH Hausgeräte GmbH, 81739 München (DE)
(72) Erfinder: Capcelea, Vladimir, 93053 Regensburg (DE); Haas, Jochen, 93055 Regensburg (DE); Hauzeneder, Christoph, 94164 Sonnen (DE); Stroka, Steffen, 93049 Regensburg (DE)

(56) Entgegenhaltungen:
- DE-A1- 102005 030 634
- US-A1- 2020 292 583
- PETE WILSON: "Application Report High-Voltage Signal Conditioning for Low-Voltage ADCs", 1 June 2004 (2004-06-01), XP055306341, Retrieved from the Internet <URL:http://www.ti.com/lit/an/sboa097/sboa097.pdf> [retrieved on 20160928]
- ANONYMOUS: "AMC1301: design amc1301 for AC voltage measurement - Amplifiers forum - Amplifiers - TI E2E support forums", 26 July 2018 (2018-07-26), pages 1 - 2, XP055910295, Retrieved from the Internet <URL:https://e2e.ti.com/support/amplifiers-group/amplifiers/f/amplifiers-forum/712951/amc1301-design-amc1301-for-ac-voltage-measurement> [retrieved on 20220407]
- ANONYMOUS: "AMC1311: Replace AMC1300 with AMC1311 for voltage measurement - Amplifiers forum - Amplifiers - TI E2E support forums", 5 October 2020 (2020-10-05), pages 1 - 3, XP055910433, Retrieved from the Internet <URL:https://e2e.ti.com/support/amplifiers-group/amplifiers/f/amplifiers-forum/945691/amc1311-replace-amc1300-with-amc1311-for-voltage-measurement> [retrieved on 20220407]
- HUTCHISON TYLER: "Matched Resistor Networks for Precision Amplifi er Applications Design Note 502", 31 December 2012 (2012-12-31), pages 1 - 2, XP055910480, Retrieved from the Internet <URL:https://www.analog.com/media/en/reference-design-documentation/design-notes/dn502f.pdf> [retrieved on 20220407]

## Beschreibung

Die Erfindung betrifft eine Vorrichtung, insbesondere eine Schaltanordnung, zur Messung einer Spannung, insbesondere einer Wechselspannung.

Ein Hausgerät, wie z.B. eine Waschmaschine oder eine Spülmaschine, weist typischerweise einen Netzanschluss, insbesondere ein Schaltnetzteil, auf, mit dem das Hausgerät an ein Wechselstrom-Versorgungsnetz angeschlossen werden kann. Die von einem Versorgungsnetz bereitgestellte Netzspannung kann Schwankungen in Bezug auf die Spannungshöhe und/oder in Bezug auf die Frequenz aufweisen. Derartige Schwankungen können zu Überspannungssituationen und/oder zu Schwankungen der Leistungsaufnahme in einem Hausgerät und somit ggf. zu Beeinträchtigungen des Betriebs des Hausgeräts führen.

Das vorliegende Dokument befasst sich mit der technischen Aufgabe, auch bei Schwankungen der Versorgungsspannung einen zuverlässigen und stabilen Betrieb eines Hausgeräts zu ermöglichen.

Die Aufgabe wird durch den Gegenstand des unabhängigen Patentanspruchs gelöst. Vorteilhafte Ausführungsformen sind insbesondere in den abhängigen Patentansprüchen definiert, in nachfolgender Beschreibung beschrieben oder in der beigefügten Zeichnung dargestellt.

Gemäß einem Aspekt der Erfindung wird eine Mess-Vorrichtung zur Messung einer AC (Alternating Current) - Eingangsspannung beschrieben. Die Mess-Vorrichtung kann insbesondere eingerichtet sein, ein Messsignal für die AC-Eingangsspannung bereitzustellen, das in zuverlässiger und effizienter Weise in einer Safety Extra Low Voltage (SELV) Umgebung von einem Mikroprozessor eingelesen werden kann. Die AC-Eingangsspannung kann z.B. eine 230V Versorgungsspannung sein. Ähnliche Mess-Vorrichtungen sind aus dem folgenden Stand der Technik bekannt: "Application Report High-Voltage Signal Conditioning for Low-Voltage ADCs" by Pete Wilson, 1. Juni 2004, URL:http:// www.ti.com/lit/an/sboa097/sboa097.pdf, "AMC1301: design amc1301 for AC voltage measurement - Amplifiers forum - Amplifiers - TI E2E support forums", 26. Juli 2018, URL:https://e2e.ti.com/ support/amplifiers-group/amplifiers/f/amplifiers-forum/712951/amc1301-design-amc1301-for-ac-voltage-measurement, US 2020/292583 A1, DE 10 2005 030634 A1 und "AMC1311: Replace AMC1300 with AMC1311 for voltage measurement - Amplifiers forum - Amplifiers - TI E2E support forums", 5. Oktober 2020 URL:https://e2e.ti.com/support/amplifiers-group/amplifiers/f/amplifiersforum/945691/amc1311-replace-amc1300-with-amc1311-for-voltage-measurement.

Die Mess-Vorrichtung umfasst einen ersten Spannungsteiler, der ausgebildet ist, einen ersten Pol, z.B. den Neutralleiter oder einen Phasenleiter, der Eingangsspannung mit einem ersten Pol zumindest eines Mess-Widerstands zu koppeln. Der zumindest eine Mess-Widerstand kann dabei ggf. ein Netzwerk von ein oder mehreren Teil-Widerständen umfassen.

Die Mess-Vorrichtung umfasst ferner einen zweiten Spannungsteiler, der ausgebildet ist, einen zweiten Pol, z.B. in komplementärer Weise zu dem ersten Spannungsteiler den Phasenleiter oder den Neutralleiter, der Eingangsspannung mit einem zweiten Pol des Mess-Widerstands zu koppeln.

Durch die Verwendung eines ersten Spannungsteilers und eines zweiten Spannungsteilers wird bewirkt, dass an dem Mess-Widerstand eine skalierte Spannung als skalierte Version der Eingangsspannung anliegt. Dabei kann die Eingangsspannung z.B. eine Amplitude von 100V oder mehr aufweisen. Andererseits kann die skalierte Spannung eine Amplitude von 50V oder weniger aufweisen. Die skalierte Spannung kann im zeitlichen Verlauf der Eingangsspannung entsprechen, jedoch eine gegenüber der Eingangsspannung reduzierte Amplitude aufweisen. Die skalierte Spannung kann eine Spannung relativ zu Masse bzw. Erde sein.

Der erste und/oder zweite Spannungsteiler weisen jeweils einen ersten Widerstand und einen zweiten Widerstand auf, die in Reihe zueinander angeordnet sind. Ggf. können die einzelnen Spannungsteiler jeweils mehr als zwei (in Reihe geschaltete) Widerstände aufweisen. Dabei weisen der erste Widerstand und/oder der zweite Widerstand jeweils einen Widerstandswert von 1MOhm oder mehr, auf. Mit anderen Worten, der erste Widerstand und/oder der zweite Widerstand können jeweils einen derart hohen Widerstandswert aufweisen, dass eine oder mehrere SELV Anforderungen, insbesondere dass die SELV Anforderung, für eine Schutzimpedanz erfüllt sind. So kann in effizienter und zuverlässiger Weise eine Skalierung der Eingangsspannung bewirkt werden.

Der erste und/oder zweite Spannungsteiler können ausgebildet sein, eine galvanische Trennung der Eingangsspannung von der skalierten Spannung zu bewirken. Alternativ oder ergänzend können der erste und/oder zweite Spannungsteiler ausgebildet sein, eine SELV Trennung zwischen der Eingangsspannung und der skalierten Spannung zu bewirken. Die galvanische Trennung und/oder die SELV Trennung können insbesondere durch die in Reihe geschalteten Widerstände der Spannungsteiler bewirkt werden. Dabei können die Widerstandswerte ausreichend hoch (z.B. 500kOhm oder mehr) und der dadurch bewirkte Strom ausreichend gering sein, um die galvanische Trennung und/oder die SELV Trennung zu bewirken. Die Widerstände können somit als Schutzimpedanz dienen. So kann eine besonders sichere Spannungsmessung ermöglicht werden.

Die Mess-Vorrichtung umfasst ferner eine Offseteinheit, die eingerichtet ist, die skalierte Spannung mittels einer Offset-Gleichspannung zu verschieben, um (als Messignal der Eingangsspannung) eine versetzte, insbesondere eine hochgesetzte, Spannung bereitzustellen. Die versetzte Spannung ist dabei derart, dass die versetzte Spannung keinen Polaritätswechsel aufweist. Mit anderen Worten, die versetzte Spannung kann derart sein, dass die versetzte Spannung (an allen Zeitpunkten) entweder nur positive Spannungswerte (≥0V) oder nur negative Spannungswerte (≥0V) aufweist. Als Folge daraus kann die versetzte Spannung als Messsignal für die Eingangsspannung in effizienter und zuverlässiger Weise an einen Mikroprozessor übergeben werden.

Die Offseteinheit kann einen Operationsverstärker mit einem ersten Eingang, insbesondere einem Plus-Eingang, für die Offset-Gleichspannung und mit einem zweiten Eingang, insbesondere einem Minus-Eingang, für die skalierte Spannung umfassen. So kann das Versetzen, insbesondere das Hochsetzen, der skalierten Spannung in besonders effizienter und zuverlässiger Weise bewirkt werden.

Die Mess-Vorrichtung kann eine Vergleichseinheit umfassen, die eingerichtet ist, die versetzte Spannung mit einer Referenzspannung zu vergleichen, um ein Komparatorsignal, insbesondere ein rechteckförmiges Komparatorsignal, zu generieren, das als Flanken Nulldurchgänge der Eingangsspannung oder eine bestimmte Phase bzw. einen bestimmten Phasenwinkel der Eingangsspannung anzeigt. Dabei kann die Referenzspannung der Offset-Gleichspannung entsprechen (insbesondere dann, wenn der Nulldurchgang bzw. die Null-Phase bzw. der Null-Phasenwinkel erkannt werden soll). Allgemein kann durch Einstellen der Referenzspannung die Phase bzw. der Phasenwinkel der Eingangsspannung festgelegt werden, die bzw. der durch die Mess-Vorrichtung erkannt werden soll.

Die Vergleichseinheit kann einen Operationsverstärker mit einem ersten Eingang, insbesondere einem Plus-Eingang, für die Referenzspannung und mit einem zweiten Eingang, insbesondere einem Minus-Eingang, für die versetzte Spannung umfassen. So können Nulldurchgänge der Eingangsspannung in effizienter und zuverlässiger Weise (in einem SELV-Bereich) angezeigt werden.

Die Mess-Vorrichtung kann einen Analog-Digital-Wandler umfassen, der eingerichtet ist, die versetzte Spannung und/oder das Komparatorsignal jeweils in ein digitales Signal zur Verarbeitung in einem Mikroprozessor zu verarbeiten. Der Analog-Digital-Wandler kann Teil des Mikroprozessors sein. So kann Information in Bezug auf die Eingangsspannung in effizienter und zuverlässiger Weise verarbeitet werden. Insbesondere können auf Basis der digitalisierten versetzten Spannung (durch einen Mikroprozessor) die Amplitude der Eingangsspannung ermittelt und/oder ein oder mehreren Nulldurchgänge der Eingangsspannung erkannt werden. Dies kann in effizienter und sicherer Weise innerhalb eines SELV-Bereichs erfolgen.

Gemäß einem weiteren Aspekt wird ein Hausgerät (z.B. eine Waschmaschine, eine Spülmaschine, ein Ofen, ein Herd, eine Küchenmaschine, ein Staubsauger, ein Trockner, ein Kühlschrank, etc.) beschrieben, das die in diesem Dokument beschriebene Mess-Vorrichtung umfasst. Das Hausgerät umfasst einen Netzanschluss zur Anbindung des Hausgeräts an eine AC-Versorgungsspannung. Die Mess-Vorrichtung kann eingerichtet sein, auf Basis der AC-Versorgungsspannung eine versetzte Spannung zu generieren.

Das Hausgerät umfasst ferner eine Steuereinheit, die eingerichtet ist, eine Funktion des Hausgeräts in Abhängigkeit von der versetzten Spannung, insbesondere in Abhängigkeit von einer Amplitude der versetzten Spannung, zu betreiben. Beispielsweise kann eine Leistungssteuerung bzw. -regelung des Hausgeräts in Abhängigkeit von der Amplitude der versetzten Spannung erfolgen. So kann ein besonders sicherer und zuverlässiger Betrieb des Hausgeräts ermöglicht werden.

Es ist zu beachten, dass jegliche Aspekte der in diesem Dokument beschriebenen Mess-Vorrichtung in vielfältiger Weise miteinander kombiniert werden können. Insbesondere können die Merkmale der Patentansprüche in vielfältiger Weise miteinander kombiniert werden.

Im Weiteren wird die Erfindung anhand von in der beigefügten Zeichnung dargestellten Ausführungsbeispielen näher beschrieben. Dabei zeigen
Figur 1 ein Blockdiagramm eines beispielhaften Hausgeräts;
Figur 2 ein Blockdiagramm einer beispielhaften Mess-Vorrichtung zur Spannungsmessung; und
Figur 3 beispielhafte zeitliche Spannungsverläufe.

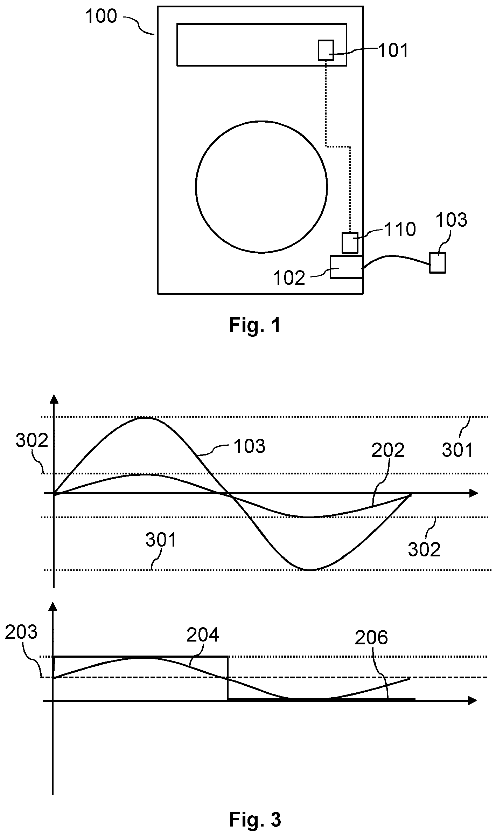

Wie eingangs dargelegt, befasst sich das vorliegende Dokument damit, auch bei Schwankungen der Versorgungsspannung in effizienter Weise einen stabilen und zuverlässigen Betrieb eines Hausgeräts zu ermöglichen. In diesem Zusammenhang zeigt Fig. 1 ein beispielhaftes Hausgerät 100, z.B. eine Waschmaschine, mit einem Netzanschluss 102, insbesondere mit einem Schaltnetzteil, über das das Hausgerät 100 an eine Wechselstrom-Versorgungsspannung 103 angeschlossen werden kann. Das Hausgerät 100 umfasst eine Mess-Vorrichtung 110, die eingerichtet ist, ein oder mehrere Messsignale in Bezug auf die Versorgungsspannung 103 zu erfassen. Die ein oder mehreren Messsignale können durch eine Steuereinheit 101, z.B. durch einen Mikroprozessor, des Hausgeräts 100 ausgewertet werden, insbesondere um den Betrieb des Hausgeräts 100 an eine jeweils aktuelle Eigenschaft, z.B. Amplitude und/oder Frequenz, der Versorgungs- bzw. Netzspannung 103 anzupassen. So kann auch bei Schwankungen der Versorgungsspannung 103 ein stabiler und zuverlässiger Betrieb des Hausgeräts 100 ermöglicht werden.

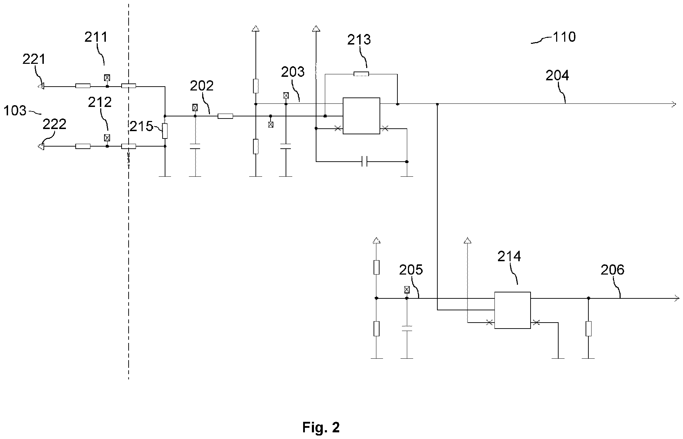

Fig. 2 zeigt ein Schaltdiagramm einer beispielhaften Mess-Vorrichtung 110. Die Mess-Vorrichtung 110 umfasst an einem Eingang 221, 222 der Mess-Vorrichtung 110 ein oder mehrere Spannungsteiler 211, 212, die eingerichtet sind, das Spannungsniveau der Versorgungsspannung 103 auf ein Niedervolt-Niveau, z.B. auf ein Niveau von weniger als 50V, zu reduzieren. Insbesondere kann die Mess-Vorrichtung 110 einen ersten Eingangs-Knoten 221 umfassen, der z.B. mit dem Neutralleiter der Versorgungsspannung 103 verbunden werden kann, und einen zweiten Eingangs-Knoten 222 umfassen, der z.B. mit einem Phasenleiter der Versorgungsspannung 103 verbunden werden kann (oder umgekehrt). Der erste Eingangs-Knoten 221 kann mit einem ersten Spannungsteiler 211 und/oder der zweite Eingangs-Knoten 222 kann mit einem zweiten Spannungsteiler 212 verbunden sein. Die Widerstände der Spannungsteiler 211, 222 können jeweils einen ohmschen Widerstand (im Bereich) von 1 MOhm aufweisen.

Ferner kann zumindest der erste Spannungsteiler 211 oder zumindest der zweite Spannungsteiler 212 mit zumindest einem Mess-Widerstand 215 gekoppelt sein, um eine skalierte Spannung 202 im SELV Bereich bereitzustellen. Insbesondere können die beiden Spannungsteiler 211, 212 mit jeweils unterschiedlichen Enden bzw. Polen zumindest eines Mess-Widerstands 215 bzw. eines Netzwerks von Mess-Widerständen 215 verbunden sein, an dem eine skalierte Spannung 202 auf Niedervolt-Niveau abfällt. Die skalierte Spannung 202 kann eine skalierte Kopie der Versorgungsspannung 103 darstellen. Die skalierte Spannung 202 kann dabei eine Spannung relativ zu Masse bzw. Erde sein. Fig. 3 zeigt eine Periode der Versorgungsspannung 103 mit einer Spannungsamplitude 301 im Hochvolt-Bereich. Des Weiteren zeigt Fig. 3 eine entsprechende Periode der skalierten Spannung 202 mit einer Spannungsamplitude 302 im Niedervolt-Bereich.

Die in Fig. 2 dargestellte Mess-Vorrichtung 110 ermöglicht durch Verwendung von Spannungsteilern 211, 212 eine galvanische Trennung der Versorgungspannung 103 (auf der linken Seite der vertikalen, gestrichelten Linie) und der skalierten Spannung 202 (auf der rechten Seite der vertikalen, gestrichelten Linie). Der rechts von der vertikalen, gestrichelten Linie angeordnete Teil der Mess-Vorrichtung 110 kann ein SELV (Safety Extra Low Voltage) Bereich sein.

Die skalierte Spannung 202 kann auf einen Eingang, insbesondere auf den Minus-Eingang, einer Offseteinheit 213 geleitet werden. Die Offseteinheit 213 kann eingerichtet sind, die skalierte Spannung 202 um eine Offset-Gleichspannung 203 zu verschieben, um eine versetzte, insbesondere eine hochgesetzte, Spannung 204 bereitzustellen. Die Offset-Gleichspannung 203 kann an einem weiteren Eingang, insbesondere an dem Plus-Eingang, der Offseteinheit 213 anliegen. Die Offseteinheit 213 kann einen Operationsverstärker umfassen. Fig. 3 zeigt die um die Offset-Gleichspannung 203 verschobene, skalierte Spannung 202, d.h. die hochgesetzte bzw. versetzte Spannung 204.

Die hochgesetzte Spannung 204 kann eine skalierte und verschobene Version der Versorgungsspannung 103 darstellen, die kein Vorzeichenwechsel aufweist, und z.B. ausschließlich positive Spannungswerte aufweist. Die hochgesetzte Spannung 204 kann in effizienter und zuverlässiger Weise durch einen Analog-Digital-Wandler z.B. eines Mikroprozessors, etwa der Steuereinheit 101 des Hausgeräts 100, eingelesen und ausgewertet werden. Die digitalisierte hochgesetzten Spannung 204 kann dann von der Steuereinheit 101 ausgewertet werden, z.B. um die Amplitude der Versorgungsspannung 103 zu ermitteln und/oder um einen Nulldurchgang der Versorgungsspannung 103 zu detektieren.

Die Mess-Vorrichtung 110 kann ferner eine Vergleichseinheit 214, insbesondere einen Komparator, umfassen, die eingerichtet ist, die hochgesetzte Spannung 204 mit einer Referenz-Gleichspannung 205 zu vergleichen, um (mittels eines Schaltungselements) ein oder mehrere Nulldurchgänge der Versorgungsspannung 103 zu detektieren. Es kann dann am Ausgang der Vergleichseinheit 214, wie in Fig. 3 dargestellt, ein Komparatorsignal 206 ausgegeben werden, das Flanken aufweist, wobei jede Flanke einen Nulldurchgang der Versorgungsspannung 103 anzeigt.

Es wird somit eine Mess-Vorrichtung 110 beschrieben, die eine galvanische Trennung der Eingangsspannung 103 anhand von Widerständen (insbesondere anhand von Schutzimpedanzen) bewirkt. Die aus der Eingangsspannung 103 abgeleitete transformierte bzw. skalierte Spannung 202 kann mit einem Operationsverstärker 213 verarbeitet werden. Insbesondere kann das skalierte AC-Spannungssignal 202 mittels einer Offset-Gleichspannung 203 hochgesetzt werden, um ein hochgesetztes Spannungssignal 204 bereitzustellen, das keine negativen Werte aufweist, und somit in zuverlässiger und präziser Weise durch einen Mikroprozessor eingelesen werden kann.

Ferner können die Nulldurchgänge der Eingangsspannung 103 an dem bereits galvanisch getrennten, hochgesetzten Spannungssignal 204 erfasst und durch einen Komparator 214 zu einem Rechtecksignal 206 verarbeitet werden, welches an einen Mikroprozessor übergegeben werden kann.

Die in diesem Dokument beschriebene Mess-Vorrichtung 110, insbesondere die beschriebene Schaltung, ermöglicht gleichzeitig eine Mehrzahl von Funktionen, wie z.B. eine Spannungsmessung, die Bereitstellung eines sicheren SELV Signals an einem Analog-Digital-Wandler (ADC), und eine Nulldurchgangsmessung (bzw. eine Phasenmessung bzw. Phasenwinkelmessung). Dabei kann die Mess-Vorrichtung 100 durch Anpassen der Offset-Gleichspannung 203 und/oder der Referenzspannung 205 in effizienter Weise an unterschiedliche Anwendungen angepasst werden.

Die in diesem Dokument beschriebene Mess-Vorrichtung 110 kann in einem elektronischen und/oder elektrischen Gerät 100 mit SELV-Trennung verwendet werden, insbesondere um eine Spannungsmessung und/oder eine Nulldurchgangserkennung für einen Mikroprozessor auf der SELV-Seite bereitzustellen.

Durch die in diesem Dokument beschriebene Mess-Vorrichtung 110 kann eine effiziente Spannungs- und/oder Nulldurchgangsmessung mit hoher Genauigkeit und mit einer hohen Temperaturstabilität bereitgestellt werden. Ferner weist die beschriebene Mess-Vorrichtung 110 eine hohe Lebensdauer auf.

Es ist zu beachten, dass die Beschreibung und die Figuren nur das Prinzip der vorgeschlagenen Mess-Vorrichtung veranschaulichen sollen. Die Erfindung wird durch die beigefügten Ansprüche definiert.

## Patentansprüche

1. Mess-Vorrichtung (110) zur Messung einer AC-Eingangsspannung (103); wobei die Mess-Vorrichtung (110) umfasst,
- einen ersten Spannungsteiler (211), der ausgebildet ist, einen ersten Pol der Eingangsspannung (103) mit einem ersten Pol zumindest eines Mess-Widerstands (215) zu koppeln, sodass an dem Mess-Widerstand (215) eine skalierte Spannung (202) als skalierte Version der Eingangsspannung (103) anliegt; und
- eine Offseteinheit (213), die eingerichtet ist, die skalierte Spannung (202) mittels einer Offset-Gleichspannung (203) zu verschieben, um eine versetzte Spannung (204) bereitzustellen, die keinen Polaritätswechsel aufweist,
- wobei die Mess-Vorrichtung (110) einen zweiten Spannungsteiler (212) umfasst, der ausgebildet ist, einen zweiten Pol der Eingangsspannung (103) mit einem zweiten Pol des Mess-Widerstands (215) zu koppeln,
- **dadurch gekennzeichnet, dass**
- der erste und zweite Spannungsteiler (211, 212) jeweils einen ersten Widerstand und einen zweiten Widerstand aufweisen, die in Reihe zueinander angeordnet sind; und
- der erste Widerstand und/oder der zweite Widerstand jeweils einen Widerstandswert von 1 MOhm oder mehr, aufweisen; und/oder
- der erste Widerstand und/oder der zweite Widerstand jeweils einen derart hohen Widerstandswert aufweisen, dass ein oder mehrere Safety Extra Low Voltage, SELV, Anforderungen für eine Schutzimpedanz erfüllt sind.

2. Mess-Vorrichtung (110) gemäß Anspruch 2, wobei der erste und zweite Spannungsteiler (211, 212) ausgebildet sind, eine galvanische Trennung der Eingangsspannung (103) von der skalierten Spannung (202) zu bewirken.

3. Mess-Vorrichtung (110) gemäß einem der Ansprüche 2 bis 3, wobei der erste und zweite Spannungsteiler (211, 212) ausgebildet sind, eine SELV Trennung zwischen der Eingangsspannung (103) und der skalierten Spannung (202) zu bewirken.

4. Mess-Vorrichtung (110) gemäß einem der vorhergehenden Ansprüche, wobei
- die Eingangsspannung (103) eine Amplitude (301) von 100V oder mehr aufweist; und
die skalierte Spannung (202) eine Amplitude (302) von 50V oder weniger aufweist.

5. Mess-Vorrichtung (110) gemäß einem der vorhergehenden Ansprüche, wobei die Offseteinheit (213) einen Operationsverstärker mit einem ersten Eingang für die Offset-Gleichspannung (203) und mit einem zweiten Eingang für die skalierte Spannung (202) umfasst.

6. Mess-Vorrichtung (110) gemäß einem der vorhergehenden Ansprüche, wobei die Mess-Vorrichtung (110) eine Vergleichseinheit (214) umfasst, die eingerichtet ist, die versetzte Spannung (204) mit einer Referenzspannung (205) zu vergleichen, um ein Komparatorsignal (206), insbesondere ein rechteckförmiges Komparatorsignal (206), zu generieren, das als Flanke jeweils eine bestimmte Phase oder einen bestimmten Phasenwinkel, insbesondere jeweils einen Nulldurchgang, der Eingangsspannung (103) anzeigt.

7. Mess-Vorrichtung (110) gemäß Anspruch 6, wobei die Vergleichseinheit (214) einen Operationsverstärker mit einem ersten Eingang, insbesondere einem Plus-Eingang, für die Referenzspannung (205) und mit einem zweiten Eingang, insbesondere einem Minus-Eingang, für die versetzte Spannung (204) umfasst.

8. Mess-Vorrichtung (110) gemäß einem der vorhergehenden Ansprüche, wobei die Mess-Vorrichtung (110) einen Analog-Digital-Wandler umfasst, der eingerichtet ist, die versetzte Spannung (204) in ein digitales Signal zur Verarbeitung in einem Mikroprozessor zu verarbeiten.

9. Hausgerät (100), das umfasst,
- einen Netzanschluss (102) zur Anbindung des Hausgeräts (100) an eine AC-Versorgungsspannung (103);
- eine Mess-Vorrichtung (110) gemäß einem der vorhergehenden Ansprüche, wobei die Mess-Vorrichtung (110) eingerichtet ist, auf Basis der AC-Versorgungsspannung (103) eine versetzte Spannung (204) zu generieren; und
- eine Steuereinheit (101), die eingerichtet ist, eine Funktion des Hausgeräts (100) in Abhängigkeit von der versetzten Spannung (204), insbesondere in Abhängigkeit von einer Amplitude der versetzten Spannung (204), zu betreiben.

## Claims

1. Measuring device (110) for measuring an AC input voltage (103); wherein the measuring device (110) comprises
- a first voltage divider (211) which is designed to couple a first pole of the input voltage (103) to a first pole of at least one measuring resistor (215) such that a scaled voltage (202) is applied to the measuring resistor (215) as a scaled version of the input voltage (103);
and
- an offset unit (213), which is configured to switch the scaled voltage (202) by means of an offset direct voltage (203) so as to provide an offset voltage (204) which has no change in polarity,
- wherein the measuring device (110) comprises a second voltage divider (212) which is designed to couple a second pole of the input voltage (103) to a second pole of the measuring resistor (215),
- **characterised in that**
- the first and second voltage divider (211, 212) each have a first resistor and a second resistor which are arranged in series relative to one another; and
- the first resistor and/or the second resistor each have a resistance value of 1 Mohm or more; and/or
- the first resistor and/or the second resistor each have a high resistance value such that one or a number of safety extra low voltage (SELV) requirements for a protective impedance are met.

2. Measuring device (110) according to claim 2, wherein the first and second voltage divider (211, 212) are designed to effect an electrical isolation between the input voltage (103) and the scaled voltage (202).

3. Measuring device (110) according to one of claims 2 to 3, wherein the first and second voltage divider (211, 212) are designed to effect a SELV isolation between the input voltage (103) and the scaled voltage (202).

4. Measuring device (110) according to one of the preceding claims, wherein
- the input voltage (103) has an amplitude (301) of 100V or more; and
the scaled voltage (202) has an amplitude (302) of 50V or less.

5. Measuring device (110) according to one of the preceding claims, wherein the offset unit (213) comprises an operational amplifier with a first input for the offset direct voltage (203) and a second input for the scaled voltage (202).

6. Measuring device (110) according to one of the preceding claims, wherein the measuring device (110) comprises a comparator unit (214) which is configured to compare the offset voltage (204) with a reference voltage (205) in order to generate a comparator signal (206), in particular a square wave comparator signal (206), which displays in each case a specific phase or a specific phase angle, in particular a zero crossing in each case, of the input voltage (103) as an edge.

7. Measuring device (110) according to claim 6, wherein the comparator unit (214) comprises an operational amplifier with a first input, in particular a plus input, for the reference voltage (205) and with a second input, in particular a minus input, for the offset voltage (204).

8. Measuring device (110) according to one of the preceding claims, wherein the measuring device (110) comprises an analogue-digital converter which is configured to process the offset voltage (204) into a digital signal for processing in a microprocessor.

9. Household appliance (100), which comprises
- a mains connection (102) for connecting the household appliance (100) to an AC supply voltage (103),
- a measuring device (110) according to one of the preceding claims, wherein the measuring device (110) is configured to generate an offset voltage (204) based on the AC supply voltage (103); and
- a control unit (101), which is configured to operate a function of the household appliance (100) as a function of the offset voltage (204), in particular as a function of an amplitude of the offset voltage (204).

## Revendications

1. Dispositif de mesure (110) pour la mesure d'une tension d'entrée à courant alternatif (103) ; dans lequel
le dispositif de mesure (110) comprend
- un premier diviseur de tension (211), lequel est développé pour coupler un premier pôle de la tension d'entrée (103) avec un premier pôle d'au moins une résistance de mesure (215) de sorte qu'une tension démultipliée (202) sur la résistance de mesure (215) est présente en tant que version démultipliée de la tension d'entrée (103) ; et
- une unité de décalage (213), laquelle est configurée pour décaler la tension démultipliée (202) au moyen d'une tension constante de décalage (203), pour procurer une tension déphasée (204) qui ne présente aucune inversion de polarité,
- lequel dispositif de mesure (110) comprend un deuxième diviseur de tension (212), lequel est développé pour coupler un deuxième pôle de la tension d'entrée (103) avec un deuxième pôle de la résistance de mesure (215),
**caractérisé en ce que**
- le premier et le deuxième diviseurs de tension (211, 212) présentent à chaque fois une première résistance et une deuxième résistance, lesquelles sont agencées en série l'une par rapport à l'autre ; et
- la première résistance et/ou la deuxième résistance présentent à chaque fois une valeur de résistance de 1 MOhm ou plus ;
et/ou
- la première résistance et/ou la deuxième résistance présentent à chaque fois une valeur de résistance suffisamment élevée pour qu'une ou plusieurs exigences en matière de Très Basse Tension de Sécurité TBTS (SELV = *Safety Extra Low Voltage*) pour une impédance de protection soient rencontrées.

2. Dispositif de mesure (110) selon la revendication 2, dans lequel le premier et le deuxième diviseurs de tension (211, 212) sont développés pour réaliser une isolation galvanique de la tension d'entrée (103) de la tension démultipliée (202).

3. Dispositif de mesure (110) selon l'une des revendications 2 à 3, dans lequel le premier et le deuxième diviseurs de tension (211, 212) sont développés pour réaliser une isolation TBTS entre la tension d'entrée (103) et la tension démultipliée (202).

4. Dispositif de mesure (110) selon l'une des revendications précédentes, dans lequel
- la tension d'entrée (103) présente une amplitude (301) de 100 V ou plus ; et
- la tension démultipliée (202) présente une amplitude (302) de 50 V ou moins.

5. Dispositif de mesure (110) selon l'une des revendications précédentes, dans lequel l'unité de décalage (213) comprend un amplificateur opérationnel comprenant une première entrée pour la tension constante de décalage (203) et une deuxième entrée pour la tension démultipliée (202).

6. Dispositif de mesure (110) selon l'une des revendications précédentes, dans lequel le dispositif de mesure (110) comprend une unité de comparaison (214) configurée pour comparer la tension déphasée (204) avec une tension de référence (205), pour générer un signal de comparateur (206), en particulier un signal de comparateur (206) rectangulaire, lequel indique par le flanc à chaque fois une phase déterminée ou un angle de phase déterminé en particulier à chaque fois un passage par zéro, de la tension d'entrée (103).

7. Dispositif de mesure (110) selon la revendication 6, dans lequel l'unité de comparaison (214) comprend un amplificateur opérationnel comprenant une première entrée, en particulier une entrée plus, pour la tension de référence (205) et comprenant une deuxième entrée, en particulier une entrée moins, pour la tension déphasée (204).

8. Dispositif de mesure (110) selon l'une des revendications précédentes, dans lequel le dispositif de mesure (110) comprend un convertisseur analogique-numérique, lequel est configuré pour traiter la tension déphasée (204) en un signal numérique pour traitement dans un microprocesseur.

9. Appareil ménager (100), lequel comprend :
- une connexion réseau (102) pour liaison de l'appareil ménager (100) à une tension d'alimentation à courant alternatif (103) ;
- un dispositif de mesure (110) selon l'une des revendications précédentes, dans lequel le dispositif de mesure (110) est configuré pour générer, sur base de la tension d'alimentation à courant alternatif (103) une tension déphasée (204) ; et
- une unité de commande (101), laquelle est configurée pour mettre en marche une fonction de l'appareil ménager (100) par rapport à la tension déphasée (204), en particulier par rapport à une amplitude de la tension déphasée (204).
